Europäisches Patentamt

European Patent Office

Office européen des brevets

(11) Publication number: **0 095 256**
**B1**

# (12) EUROPEAN PATENT SPECIFICATION

(45) Date of publication of patent specification: 26.03.86

(51) Int. Cl.⁴: **H 05 K 3/02, H 05 K 3/24**

(21) Application number: 83302398.9

(22) Date of filing: 28.04.83

(54) **Method of making printed circuits.**

(30) Priority: 21.05.82 US 380585

(43) Date of publication of application:
30.11.83 Bulletin 83/48

(45) Publication of the grant of the patent:
26.03.86 Bulletin 86/13

(84) Designated Contracting States:
DE FR GB

(56) References cited:
DE-A-2 522 006
DE-A-2 652 428

(73) Proprietor: Hewlett-Packard Company
Mail Stop 20 B-O 3000 Hanover Street
Palo Alto California 94304 (US)

(72) Inventor: Obermaier, Hannsjorg
20195 Beatty Ridge Road
Los Gatos California 95030 (US)

(74) Representative: Squibbs, Robert Francis
Hewlett-Packard Limited Nine Mile Ride
Wokingham Berkshire RG11 3LL (GB)

Courier Press, Leamington Spa, England.

## Description

This invention is concerned with a method of making printed circuits.

Precious metal contacts for electrical inter-connections to other devices are generally required for most printed circuit boards. Unfortunately, such precious metals are a major cost component in the manufacture of the printed circuit board and are sensitive to large cost fluctuations. However, since low contact resistance precious metals are only required at the actual points of contact there have been various selective plating techniques to confine the application of precious metals to these areas. A further consideration for selective plating has been the desire to avoid the deposition of low melting temperature metals such as tin or lead under the solder resist.

One technique for accomplishing selective metal plating is the application of tape to mask off the areas not requiring contact metals. This is a time-consuming method that become prohibitively expensive if the contacts are randomly distributed over the entire area of the circuit board.

Another technique used is to tab or tip plate the circuit board by controlled immersion. The major disadvantage with this system is that it allows only contact areas on the periphery and in a straight line to be plated.

A third technique is the selective plating of various metals sequentially after covering previously deposited metals with a mask and prior to the removal of the base foil. This method does permit selective plating randomly on the circuit board; however, it is both expensive and inconvenient, since it adds additional process steps and interrupts the process flow. This method of masking, plating, then masking and plating again requires a substantial increase in both masking and plating capacity, and thus cost increases in order to maintain the same output quantity of circuit boards.

The present invention provides a method of making printed circuits on a metal foil clad substrate characterized by the ordered steps of (a) coating with a first permanent mask in the positive image all substrate areas on which no subsequent deposition or removal of material is desired; (b) coating with a second temporary mask all substrate areas on which no further deposition is desired; (c) depositing a first metal layer on all areas uncoated by said first and said second masks; (d) depositing a second metal layer dissimilar from said first metal layer on said first metal layer; (e) removing said second mask; and (f) removing the metal foil cladding previously underlying said second mask.

The present invention further provides a method of making printed circuits on a metal foil clad substrate having one or more holes therethrough, and comprising the step of (a) depositing an electroless metal on said substrate and within said holes; and characterized by the ordered steps of (b) coating with a first permanent mask in the positive image all substrate areas on which no subsequent deposition or removal of material is desired; (c) coating with a second temporary mask all substrate areas on which no further deposition is desired; (d) depositing a first metal layer on all areas uncoated by said first and said second masks; (e) depositing a second metal layer dissimilar from said first metal layer on said first metal layer; (f) removing said second mask; and (g) removing the metal foil cladding previously underlying said second mask.

In carrying out a method as set forth in either one of the last two immediately preceding paragraphs, it is preferred that a final step is provided which comprises selectively depositing a conformal coating on said substrate and selected portions of said metal layers.

Said first metal layer is preferably of copper and said second metal layer is preferably a compound layer of either tin over nickel or gold over nickel.

In accordance with the illustrated embodiment of the invention, a method is disclosed for the selective plating of printed circuit boards. A standard method for the manufacture of circuit boards, called the Type 1 process, which does not permit selective plating, is modified in a new and novel way without the addition of new process steps. The result of this modification is the capability of selectively plating areas anywhere on the circuit board; this process, called the $H_2O$ process, is made possible by a unique combination of permanent positive and temporary negative masks.

With the novel $HO_2$ process, the traditional permanent solder masking operation, normally performed after etching, is done first, during the primary imaging step on all areas where no subsequent plating is desired. This first mask then functions as both a trace-defining etch resist and as a solder resist. Next, the negative image of all areas, such as pads, holes and connectors, which are later to be selectively plated, is printed with a temporary, strippable mask. The circuit board is then plated with the desired sequence of metals, such as copper, then nickel, then gold on the areas where neither the permanent nor the temporary mask is present. The temporary mask is then stripped away by an appropriate method, followed by the etching away of the base metal which had previously underlain the temporary mask.

The result is the desired pattern of traces made of the base cladding metal and coated by a permanent solder mask, and areas such as pads, holes, and connectors selectively plated as desired.

A final step can be the application of a conformal coating to protect the board more fully from corrosion in harsh environments.

There now follows a detailed description, which is to be read with reference to the accompanying drawings, of a prior art method and a method according to the invention; it is to be clearly understood that the method according to the invention has been selected for description to illustrate the invention by way of example and not by way of limitation.

In the accompanying drawings:—

Figure 1A is a sectional perspective view of an ordinary, Type 1, printed circuit board;

Figure 1B illustrates a printed circuit board provided by a process according to the invention; and

Figure 2 is a comparison of the process flow for a Type 1 versus a HO$_2$ processed printed circuit board.

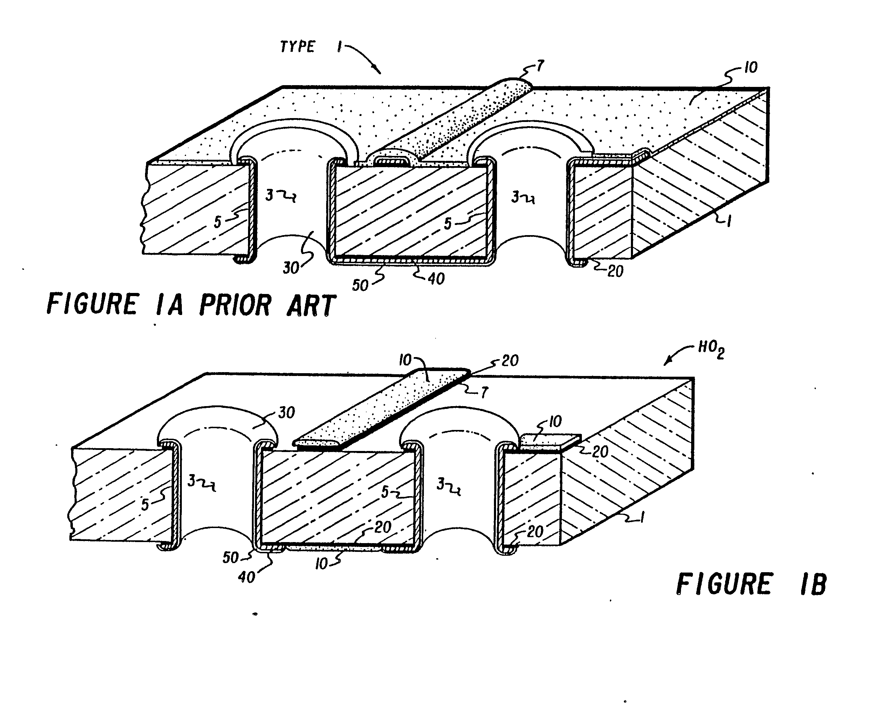

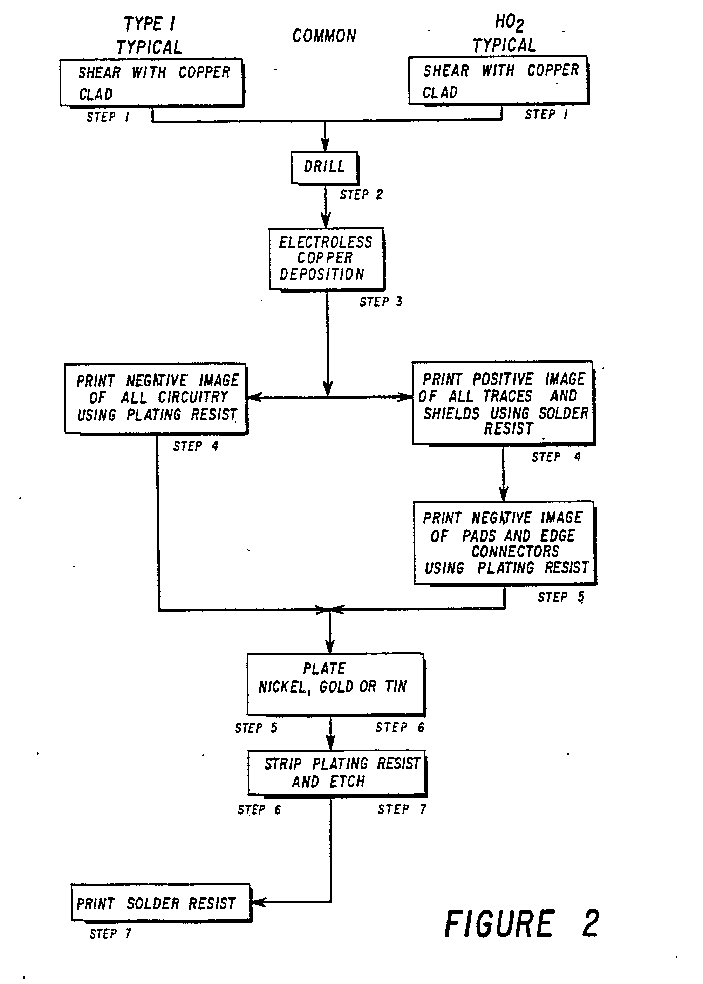

In Figures 1 and 2 there is shown a finished circuit board and the process flow for both the Type 1 and HO$_2$ processes. Steps 1 to 3 are essentially the same for both processes. In step 1, a base board material 1, made of an insulating material such as resin impregnated glass fibre, is clad with a base metal layer 20. This clad substrate 20 may be stock material having, for example, one ounce per square of copper foil with a thickness of approximately .034 mm. The clad substrate 20 is then sheared to the size necessary for processing. In step 2, holes 3 which are to be plated are drilled or punched. Then in step 3 the entire circuit board is electrolessly deposited with a thin layer of metal 5 such as copper. All of these preliminary steps are well known in the prior art.

In the standard Type 1 process the fourth step is to print the negative image of all traces and pads with a temporary mask which will permit the deposition of later metals onto the runs and pads. This temporary mask is not affected by the plating process, but can be removed later by appropriate methods such as alkali stripping. In the Type 1 process, the circuit board is then plated in step 5 with copper 40, nickel 50, then gold 30; the plating resist is stripped and the board is etched in step 6; and the board is printed with solder resist 10 in step 7.

In the HO$_2$ process, the primary imaging step is quite different. In step 4 of the HO$_2$ process, the first mask is a permanent mask 10, which will later serve as solder resist when the board is loaded with components and is ready for soldering. This permanent mask 10 is printed in the positive image at all locations which are not to be further plated and at the same time are not be removed by etching, such as traces and shields 7. Typically, this permanent mask 10 is an ultra-violet or heat curable polymer and can be the same material as is used in the Type 1 process in step 7. It is also possible to pick the permanent solder resist material with the appropriate color so that the resulting circuit board has a gold color which may be pleasing to the end users without the need for using expensive gold to cover the base metal. In the case of base copper cladding, the appropriate permanent mask color has proven to be light green. Another alternative is to use a thermally conductive coating such as black cupric oxide prior to the application of the permanent mask. This greatly enhances the adhesion of the permanent mask and therefore improves the circuit board's resistance to mechanical abuse during circuit board assembly.

Step 5 of the HO$_2$ process is a second imaging step consisting of printing of a negative image to expose all places which are to be selectively plated, such as pads and connectors 3. This second masking operation provides a temporary mask similar to that used in step 4 of the Type 1 process, but only the pads and connectors 3 are exposed to the electrolyte during the plating cycle. It should also be noted that doing two imaging steps back-to-back as in the HO$_2$ process is not significantly more costly than the first imaging step in Type 1 process, but is less expensive than the two masking operations (steps 4 and 7) done in the Type 1 process and separated in time by the plating, stripping and etching operations.

Steps 6 and 7 of the HO$_2$ process are again the standard process steps done in a new order of plating with the appropriate metals, stripping the temporary mask applied in step 5, and etching away the unwanted base cladding 20 and electroless metal 5 to create the desired circuit pattern 7. The plated metals are often gold 30, over nickel 50, over copper 40, but other combinations are well known, such as tin over nickel over copper. Any such combination is susceptible to selective plating as taught in the claimed invention by one skilled in the art.

Several features of the HO$_2$ process should be noted: firstly, since only base copper, which has a melting point of approximately 1083°C, is under the solder mask, tendency of the solder mask to wrinkle during the subsequent wave solder operation due to the reflow of underlying metal as in the Type 1 process with tin is eliminated. Secondly, since there is no multiple combination of metals on the dense circuit areas of the circuit board, the environmental problems of galvanic corrosion and tin migration (i.e., "whiskers") between adjacent traces are greatly reduced. Finally, it has been found that in high frequency applications, the HO$_2$ process yields circuit boards with attenuation losses comparable to plain copper circuit boards and superior to circuit boards with a nickel or thick gold finish on all of the electrically active traces.

It should be noted that the previous discussion has focussed on two sided circuit boards, but it would be clear to one skilled in the art that the claimed process is also applicable to single-sided as well as multi-layer circuit boards.

**Claims**

1. A method of making printed circuits on a metal foil clad substrate characterized by the ordered steps of:

(a) coating with a first permanent mask (10) in the positive image all substrate areas on which no subsequent deposition or removal of material is desired;

(b) coating with a second temporary mask all substrate areas on which no further deposition is desired;

(c) depositing a first metal layer (40) on all areas uncoated by said first and said second masks;

(d) depositing a second metal layer (50, 30) dissimilar from said first metal layer on said first metal layer;

(e) removing said second mask; and

(f) removing the metal foil cladding previously underlying said second mask.

2. A method of making printed circuits on a metal foil clad substrate having one or more holes therethrough, and comprising the step of

(a) depositing an electroless metal on said substrate and within said holes; and characterized by the ordered steps of

(b) coating with a first permanent mask (10) in the positive image all substrate areas on which no subsequent deposition or removal of material is desired;

(c) coating with a second temporary mask all substrate areas on which no further deposition is desired;

(d) depositing a first metal layer (40) on all areas uncoated by said first and said second masks;

(e) depositing a second metal layer (50, 30) dissimilar from said first metal layer on said first metal layer;

(f) removing said second mask; and

(g) removing the metal foil cladding previously underlying said second mask.

3. A method according to any one of claims 1 and 2 characterized by a final step of selectively depositing a conformal coating on said substrate and selected portions of said metal layers.

4. A method according to any one of the preceding claims characterized in that said first metal layer is copper.

5. A method according to any one of the preceding claims characterized in that said second metal layer is a compound layer of tin over nickel.

6. A method according to any one of claims 1 to 4 characterized in that said second metal layer is a compound layer of gold over nickel.

**Patentansprüche**

1. Verfahren zum Herstellen von Druckschaltungen auf einem mit Metallfolie beschichteten Substrat, gekennzeichnet durch die geordneten Schritte des:

(a) Beschichtens mit einer ersten festen Maske (10) in positiver Abbildung aller Substratbereiche, auf denen keine nachfolgende Ablagerung oder Beseitigung von Werkstoff gewünscht wird;

(b) Beschichtens mit einer zweiten provisorischen Maske aller Substratbereiche, auf denen keine weitere Ablagerung gewünscht wird;

(c) Aufbringens einer ersten Metallschicht (40) auf alle durch besagte erste und besagte zweite Masken unbeschichtete Bereiche;

(d) Aufbringens einer von derbesagten ersten Metallschicht unterschiedlichen zweiten Metallschicht (50, 30) auf besagte erste Metallschicht;

(e) Entfernens der besagten zweiten Maske; und

(f) Entfernens der vorher unter der besagten zweiten Maske liegenden Metallfolienbeschichtung.

2. Verfahren zum Herstellen von Druckschaltungen auf einem mit Metallfolie beschichteten Substrat mit einer oder mehreren dieses durchdringenden Bohrungen und den Schritt des

(a) Aufbringens eines stromlosen Metalls auf besagtes Substrat und in besagten Bohrungen unfassend; und gekennzeichnet durch die geordneten Schrittes des

(b) Beschichtens mit einer ersten festen Maske (10) in positiver Abbildung aller Substratbereiche, auf denen keine nachfolgende Ablagerung oder Beseitigung von Werkstoff gewünscht wird;

(c) Beschichtens mit einer zweiten provisorischen Maske aller Substratbereiche, auf denen keine weitere Ablagerung gewünscht wird;

(d) Aufbringens einer ersten Metallschicht (40) auf alle mit besagten ersten und besagten zweiten Masken unbeschichtete Bereiche;

(e) Aufbringens einer von der besagten ersten Metallschicht unterschiedlichen zweiten Metallschicht (50, 30) auf besagte erste Metallschicht;

(f) Entfernens der besagten zweiten Maske; und

(g) Entfernens der vorher unter der besagten zweiten Maske liegenden Metallfolienbeschichtung.

3. Verfahren nach einem der Ansprüche 1 und 2, gekennzeichnet durch einen Schlussschritt des gezielten Aufbringens einer konformen Beschichtung auf besagtes Substrat und ausgewählte Teile der besagten Metallschichten.

4. Verfahren nach einem der vorhergehenden Ansprüche, dadurch gekennzeichnet, dass die besagte erste Metallschicht Kupfer ist.

5. Verfahren nach einem der vorhergehenden Ansprüche, dadurch gekennzeichnet, dass die besagte zweite Metallschicht eine Verbundschicht von Zinn über Nickel ist.

6. Verfahren nach einem der Ansprüche 1 bis 4, dadurch gekennzeichnet, dass die besagte zweite Metallschicht eine Verbundschicht von Gold über Nickel ist.

**Revendications**

1. Procédé pour fabriquer des circuits imprimés sur un substrat doublé d'une feuille de métal, caractérisé par les stades dans l'ordre:

(a) de revêtir au moyen d'un premier masque permanent (10) dans l'image positive toutes les régions du substrat sur lesquelles aucun dépôt ni élimination ultérieurs de matière ne sont souhaités;

(b) de revêtir au moyen d'un second masque temporaire toutes les régions du substrat sur lesquelles aucun dépôt ultérieur n'est souhaité;

(c) de déposer une première couche de métal (40) sur toutes les régions non recouvertes par le premier masque et le second;

(d) de déposer une seconde couche de métal (50, 30) dissemblable de la première couche de métal sur la première couche de métal;

(e) d'éliminer le second masque, et

(f) d'éliminer la feuille de métal de doublage se trouvant antérieurement sous le second masque.

2. Procédé pour fabriquer des circuits imprimés sur un substrat doublé d'une feuille de métal comportant un ou plusieurs trous de part en part, comprenant les stades

(a) de déposer un métal non électrolytiquement sur le substrat et dans les trous, et caractérisé par les stades dans l'ordre:

(b) de revêtir au moyen d'un premier masque permanent (10) dans l'image positive toutes les régions du substrat sur lesquelles aucun dépôt ni élimination ultérieurs de matière ne sont souhaités;

(c) de revêtir au moyen d'un second masque temporaire toutes les régions du substrat sur lesquelles aucun dépôt ultérieur n'est souhaité;

(d) de déposer une première couche de métal (40) sur toutes les régions non recouvertes par le premier masque et le second;

(e) de déposer une seconde couche de métal (50, 30) dissemblable de la première couche de métal sur la première couche de métal;

(f) d'éliminer le second masque, et

(g) d'éliminer la feuille de métal de doublage se trouvant antérieurement sous le second masque.

3. Procédé suivant l'une quelconque des revendications 1 et 2, caractérisé par un stade final de dépôt sélectif d'un revêtement conforme sur le substrat et des parties sélectionnées des couches métalliques.

4. Procédé suivant l'une quelconque des revendications précédentes, caractérisé en ce que la première couche de métal est en cuivre.

5. Procédé suivant l'une quelconque des revendications précédentes, caractérisé en ce que la second couche de métal est une couche mixte d'étain sur du nickel.

6. Procédé suivant l'une quelconque des revendications 1 à 4, caractérisé en ce que la second couche de métal est une couche mixte d'or sur du nickel.

TYPE I

FIGURE IA PRIOR ART

FIGURE IB

0 095 256

TYPE I
TYPICAL

COMMON

$HO_2$
TYPICAL

SHEAR WITH COPPER CLAD
STEP I

SHEAR WITH COPPER CLAD
STEP I

DRILL
STEP 2

ELECTROLESS COPPER DEPOSITION
STEP 3

PRINT NEGATIVE IMAGE OF ALL CIRCUITRY USING PLATING RESIST
STEP 4

PRINT POSITIVE IMAGE OF ALL TRACES AND SHIELDS USING SOLDER RESIST
STEP 4

PRINT NEGATIVE IMAGE OF PADS AND EDGE CONNECTORS USING PLATING RESIST
STEP 5

PLATE
NICKEL, GOLD OR TIN
STEP 5          STEP 6

STRIP PLATING RESIST AND ETCH
STEP 6          STEP 7

PRINT SOLDER RESIST
STEP 7

FIGURE 2

2